Europäisches Patentamt

European Patent Office

Office européen des brevets

(19)

(11) Numéro de publication : **0 036 354**
**B1**

(12) **FASCICULE DE BREVET EUROPÉEN**

(45) Date de publication du fascicule du brevet :
**13.06.84**

(21) Numéro de dépôt : **81400335.6**

(22) Date de dépôt : **04.03.81**

(51) Int. Cl.³ : **G 01 R 29/26**, G 01 R 29/00,
H 04 N 9/62

(54) **Dispositif d'acquisition et de moyennage des échantillons d'un signal périodique bruité.**

(30) Priorité : **17.03.80 FR 8005928**

(43) Date de publication de la demande :
**23.09.81 Bulletin 81/38**

(45) Mention de la délivrance du brevet :
**13.06.84 Bulletin 84/24**

(84) Etats contractants désignés :
**BE CH DE GB IT LI NL SE**

(56) Documents cités :
**DE-A- 2 700 772**
**FR-A- 2 031 132**
**FR-A- 2 290 114**

(73) Titulaire : **Etablissement Public Télédiffusion de France**
**10, rue d'Oradour-sur-Glane**
**F-75015 Paris (FR)**

(72) Inventeur : **Reneric, Michel**
**23, rue Rosenwald**
**F-75015 Paris (FR)**

(74) Mandataire : **Cabinet Martinet**
**62, rue des Mathurins**
**F-75008 Paris (FR)**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

Jouve, 18, rue St-Denis, 75001 Paris, France

## Description

La présente invention concerne un dispositif d'acquisition et de moyennage des échantillons d'un signal périodique bruité, dont la période est composée d'une première partie avec signal et d'une seconde partie sans signal.

Bien que l'invention ne soit pas limitée au domaine de la transmission d'un signal de télévision, le signal périodique bruité peut être en particulier l'un des signaux d'essai qui est inséré dans des lignes spécifiques de l'intervalle de suppression de trame d'un signal de télévision. Les caractéristiques de ces signaux d'essai d'insertion et les paramètres à mesurer à partir de ceux-ci pour déterminer la qualité d'un système de transmission de signal de télévision sont spécifiés dans les avis A 473-2 (1970) et A 569 (1978) publiés par le Comité Consultatif International de Radiocommunications (CCIR).

Dans l'art antérieur sont déjà connus des appareils qui mesurent automatiquement les distorsions subies par les signaux d'essai d'insertion et qui évaluent la qualité du signal en différents points du moyen de transmission du signal de télévision.

Ces appareils de mesure peuvent être classés en deux catégories.

Les appareils de mesure de la première catégorie, de loin les plus nombreux, commercialisés par les Sociétés Rohde & Schwarz, A GEC-Marconi Electronics Company et S.A. Philips, utilisent des dispositifs classiques d'acquisition et de moyennage du signal qui comprennent principalement les circuits suivants. A l'entrée du signal bruité est insérée une pluralité de circuits d'échantillonnage et de maintien analogiques classiques qui sont en nombre égal au nombre d'échantillons à acquérir. Chacun de ces circuits d'échantillonnage et de maintien est organisé autour d'un commutateur qui est fermé pendant la durée d'échantillonnage sur un condensateur destiné à mémoriser, sous la forme d'une tension continue, la tension échantillonnée. Puis, éventuellement, des circuits analogiques filtrant les tensions échantillonnées. Puis, éventuellement, des circuits analogiques filtrant les tensions échantillonnées permettent de moyenner leurs fluctuations en présence de bruit de fond. Après ce filtrage, des unités de calcul analogiques constituées par exemple d'amplificateurs opérationnels, calculent les différents paramètres à mesurer à partir des tensions échantillonnées et délivrent les signaux représentant les paramètres sous la forme de tensions continues. A la sortie des unités de calcul est relié un convertisseur analogique numérique lent qui convertit séquentiellement, sous forme numérique, les tensions continues délivrées par les unités de calcul. Selon cette première catégorie, il apparaît que les paramètres sont d'abord acquis sous forme analogique, ce qui présente l'inconvénient de mettre en œuvre une unité de calcul analogique de coût relativement élevé. Il en résulte que le nombre d'échantillons est réduit.

Les appareils de la seconde catégorie, plus récents, commercialisés par la Société Tektronix, Inc. font plus largement appel aux techniques numériques. Le signal bruité à analyser est échantillonné à une fréquence très élevée et supérieure à la fréquence de Nyquist. Chaque échantillon est instantanément converti sous forme numérique à l'aide d'un convertisseur analogique-numérique rapide. Les valeurs numériques relatives à chaque échantillon, pour plusieurs périodes successives du signal bruité, sont rangées dans une mémoire. A la fin de ces périodes successives un microprocesseur lit les valeurs numériques mémorisées pour chaque échantillon et calcule, pour ces périodes successives, la valeur moyenne de l'échantillon, au sens mathématique du terme. La valeur de l'échantillon est alors très imprécise si le signal est fortement bruité pendant lesdites périodes successives.

Par ailleurs, il est connu que les convertisseurs analogiques-numériques rapides actuels ont une résolution relativement faible, au maximum 8 bits par échantillon, ce qui limite la précision de l'échantillonnage et par suite du moyennage dans les appareils de mesure selon la seconde catégorie.

Un appareil permettant de déduire un paramètre de qualité de télévision à partir d'un signal d'essai est décrit dans la demande de brevet FR-A-2 290 114 et comprend également un convertisseur analogique-numérique précédant un dispositif analogique d'échantillonnage.

La présente invention a pour but de fournir un dispositif d'acquisition et de moyennage d'un signal périodique bruité s'affranchissant des inconvénients ci-dessus évoqués par le fait qu'il met en œuvre un convertisseur numérique-analogique à haute résolution et de coût plus réduit qu'un convertisseur analogique-numérique qui par construction est à faible résolution, et une unité de calcul des valeurs numériques des échantillons à acquérir qui comprend essentiellement des composants numériques, ce qui permet de traiter directement sous forme numérique les échantillons en vue du calcul des paramètres. En outre, le dispositif selon l'invention assure une acquisition des valeurs numériques des échantillons à la fois rapide et insensible au bruit de fond.

A cette fin, un dispositif d'acquisition et de moyennage des échantillons d'un signal périodique bruité est tel que caractérisé dans la revendication 1.

Le principe de base du dispositif selon l'invention est le suivant. Au moyen de valeurs numériques contenues dans une mémoire et au moyen d'un convertisseur numérique-analogique, un signal synthétisé analogique est produit pendant la première partie de chaque période du signal bruité. Le signal synthétisé et le signal bruité sont comparés à des instants d'échantillonnage prédéterminés dont le nombre et les positions temporelles dans la première partie de période sont sélectionnés en fonction de la forme du signal bruité, de son spectre et de la nature des mesures à effectuer.

Puis les résultats des comparaisons, tels que le signe du signal d'erreur et la grandeur du module du signal d'erreur relativement au seuil de tension prédéterminé, sont écrits dans la mémoire. Pendant la seconde partie de chaque période correspondant à l'absence du signal bruité, telle que la durée de trame utile pour l'acquisition d'un signal d'essai d'insertion en télévision, une unité de traitement, comme un microprocesseur, effectue le calcul des nouvelles valeurs numériques des échantillons en fonction des résultats de comparaison et des valeurs numériques des échantillons précédents, selon un algorithme particulier. Puis les nouvelles valeurs numériques des échantillons sont à nouveau converties sous formes d'un signal analogique lors de la première partie de période suivante.

En régime établi le signal synthétisé coïncide avec la valeur moyenne du signal entrant bruité à analyser, aux instants d'échantillonnage prédéterminés.

Les moyens de calcul numériques mettant en œuvre l'algorithme particulier sont tels que définis dans la revendication 2.

L'algorithme utilisé dans le dispositif selon l'invention, pour le calcul du signal synthétisé permet d'obtenir un excellent compromis entre la vitesse d'acquisition et la réduction du bruit. Les valeurs numériques du signal synthétisé sont disponibles en mémoire, après acquisition en régime établi, et peuvent être utilisées pour le calcul des paramètres à mesurer.

D'autres avantages de la présente invention apparaîtront plus clairement à la lecture de la description qui suit d'exemples de réalisation et à l'examen des dessins annexés correspondants, dans lesquels :

la Figure 1 est un bloc-diagramme schématique du capteur du dispositif d'acquisition et de moyennage destiné à acquérir les résultats de comparaison ;

la Figure 2 est un diagramme de formes d'onde montrant les différents signaux obtenus à la suite des comparaisons dans le capteur ;

la Figure 3 est un bloc-diagramme détaillé d'un exemple préféré de l'horloge à pas variable du capteur ;

la Figure 4 est un diagramme de formes d'onde montrant l'échantillonnage à pas variable ;

la Figure 5 est un bloc-diagramme schématique de l'unité de traitement du dispositif destinée à moyenner les échantillons, selon une réalisation à microprocesseur ; et

la Figure 6 est un bloc-diagramme détaillé d'une partie de l'unité de traitement selon une réalisation en logique cablée, pour calculer la valeur numérique d'un échantillon à partir des résultats de comparaison.

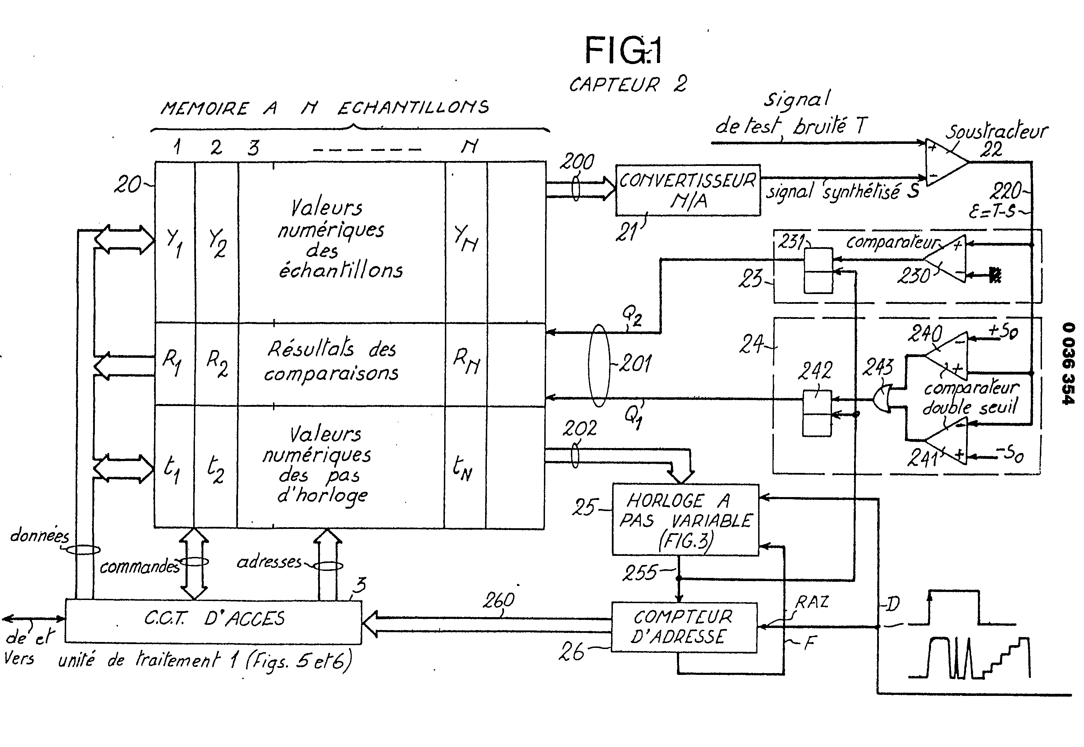

Le dispositif d'acquisition et de moyennage selon l'invention est constitué essentiellement par une unité de traitement 1 et par un capteur 2. L'unité de traitement 1 est destinée au calcul des valeurs numériques des échantillons du signal synthétisé et sera détaillée plus loin. Le capteur 2 est montré à la Figure 1 et est destiné à capter les caractéristiques du signal d'erreur, dit de différence, pour chaque échantillon. Le signal d'erreur $\varepsilon$ représente la différence entre le signal synthétisé calculé par l'unité de traitement 1 et le signal de test bruité à analyser T.

Tel que montré à la Fig. 1, le capteur 2 est organisé autour d'une mémoire à accès aléatoire 20 qui est entièrement sous le contrôle de l'unité de traitement 1 lorsque le capteur 2 ne reçoit pas le signal de test T. La mémoire 20 est partagée en trois séries de cellules Y, R et t qui sont composées chacune d'un nombre de cellules élémentaires égal ou supérieur au nombre entier N d'échantillons à acquérir. La première série $Y_1$ à $Y_N$ contient des mots à 12 bits, par exemple, qui représentent les valeurs numériques des échantillons. La seconde série de cellules $R_1$ à $R_N$ contient des mots à 2 bits $Q_1$, $Q_2$ qui indiquent le résultat des comparaisons du signal synthétisé et du signal de test bruité. L'état du premier bit $Q_1$ d'un mot R indique si le module $|\varepsilon|$ du signal d'erreur $\varepsilon$ est inférieur ou supérieur à un seuil prédéterminé $S_0$. L'état du second bit $Q_2$ d'un mot R indique le signe du signal d'erreur $\varepsilon$. La troisième série de cellules $t_1$ à $t_N$ de la mémoire 20 contient des mots à 4 bits, par exemple, qui représentent les valeurs numériques des pas élémentaires d'un cycle d'échantillonnage.

Dans le capteur 2, les résultats des comparaisons pour chaque échantillon sont principalement obtenus au moyen des circuits composants 21 à 24. L'échantillon numérique $Y_n$, où n est un entier variant de 1 à N, est lu après une durée égale à $\sum_1^{n-1} t_n$ dans la mémoire 20 qui le transmet à un convertisseur numérique-analogique 21, à travers un bus 200 à 12 fils. L'échantillon analogique $S_n$ est transmis par le convertisseur 21 vers l'entrée inverse (−) d'un soustracteur 22. L'entrée directe (+) du soustracteur 22 reçoit le signal de test bruité périodique T. Ce signal de test peut être, comme déjà dit, un signal standard tel que les signaux d'essai insérés dans les lignes No 17 à 22 d'un signal vidéo. Par exemple ce signal de test T a une période de 20 ms — égale à la période de trame d'image — et à une première partie ayant une durée $\sum_1^N t_n$ de l'ordre de 0,38 ms — c'est-à-dire de l'ordre de 6 fois la période de ligne de 64 μs du signal vidéo correspondant —. La durée maximale disponible pour traiter les résultats des comparaisons est au plus égale à la seconde partie de la période du signal de test, soit de l'ordre de 19,6 ms. Le début du signal de test selon cet exemple est l'instant correspondant à la demi-amplitude du front montant de la barre de luminance du signal d'essai inséré dans la ligne No 17 du signal vidéo, comme montré au-dessus du fil D dans la Fig. 1.

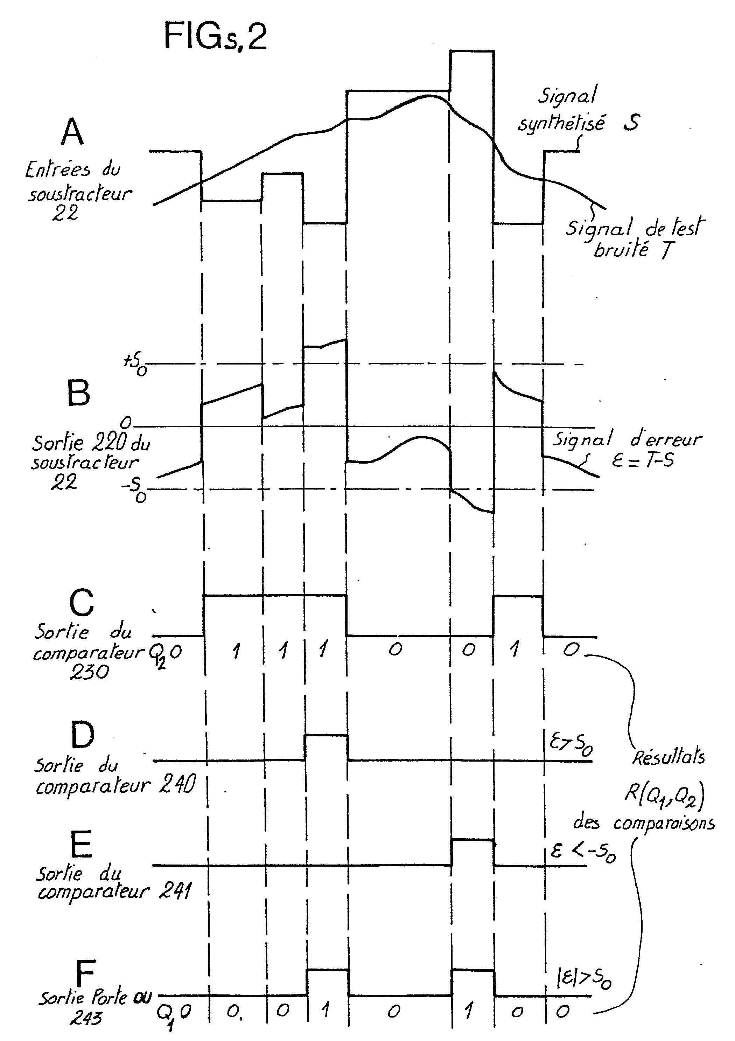

La sortie 220 du soustracteur 22 fournit l'échantillon analogique $\varepsilon_n$ du signal d'erreur $\varepsilon = T − S$. Un exemple de signal d'erreur $\varepsilon$ est

montré à la Fig. 2B pour un signal synthétisé S et un signal de test bruité T montrés à la Fig. 2A. Le signal d'erreur est appliqué à l'entrée directe (+) d'un circuit de comparaison à zéro 23 et à des entrées directes (+) et inverses (−) d'un circuit de comparaison à double seuil 24. Les circuits de comparaison 23 et 24 comprennent classiquement des amplificateurs opérationnels fonctionnant en comparateur. Le circuit 23 comprend un comparateur à zéro 230 dont le signal de sortie est montré à la Fig. 2C et est transmis à une bascule bistable 231. Le circuit 24 comporte deux comparateurs 240 et 241 qui comparent le signal $\varepsilon$, respectivement à la valeur du seuil prédéterminé $S_0$ et à sa valeur opposée $-S_0$. Les signaux de sortie des comparateurs 240 et 241 sont représentés aux Figs. 2D et 2E. Le circuit 24 comprend également une bascule bistable 242 dont l'entrée est reliée aux sorties des comparateurs 240 et 241 à travers une porte OU 243. Le signal logique à la sortie de la porte OU 243 est montré à la Fig. 2F. Il est à l'état haut si $|\varepsilon| > S_0$, ce qui correspond à l'écriture d'un premier bit $Q_1 = 1$ dans la cellule correspondante $R_n$ de la mémoire 20. Le signal logique transmis par la sortie du comparateur 23 (Fig. 2C) est représentatif du signe du signal d'erreur $\varepsilon$ ; il est à l'état haut si $\varepsilon > 0$, ce qui correspond à l'écriture d'un second bit $Q_2 = 1$ dans la cellule correspondante $R_n$. Les deux écritures précédentes sont effectuées à la fin du pas élémentaire correspondant $t_n$ sous la commande d'un signal d'horloge 255 qui est appliqué aux entrées d'horloge des bascules 231 et 242.

L'échantillonnage à pas variable $t_1$ à $t_N$ est réalisé au moyen d'une horloge à pas variable 25 et d'un compteur d'adresse 26. Les valeurs numériques $t_1$ à $t_N$ sont choisies préalablement en fonction des caractéristiques de la partie du signal de test à analyser, qui est au plus égale à ladite première partie de ce signal.

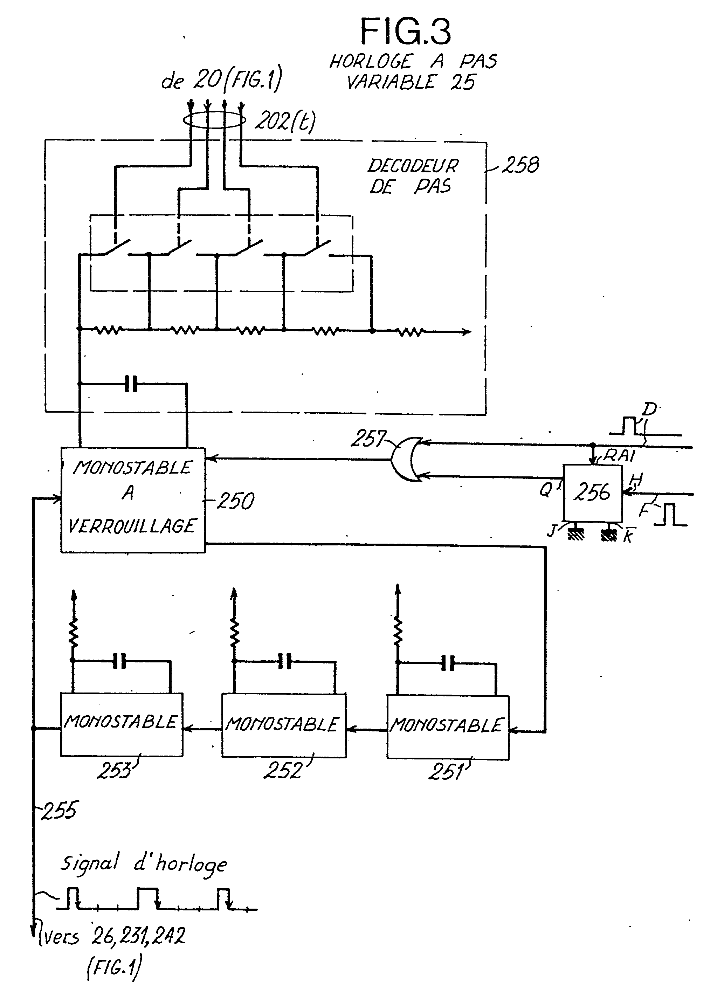

L'horloge 25 comprend, selon un exemple préféré illustré à la Fig. 3, une boucle de bascules monostables 250 à 253 qui est déverrouillée pendant la durée séparant deux signaux qui indiquent le début et la fin de la première partie du signal de test à acquérir et qui sont appliqués aux entrées D et F de l'horloge 25, respectivement. La boucle de bascules comprend trois bascules monostables 251 à 253 en série qui sont excitées par un front descendant sur leurs entrées afin de produire chacune une impulsion ayant une durée de 1 µs par exemple. Trois bascules monostables sont utilisées au lieu d'une pour des fins de stabilisation en température. L'entrée de la première bascule monostable 251 est reliée à la sortie de la bascule 250 qui est une bascule à verrouillage. La sortie de la dernière bascule 253 constitue la sortie 255 de l'horloge 25 qui est reliée à l'entrée de la bascule 250 et également à l'entrée de comptage du compteur d'adresse 26 et aux entrées d'horloge des bascules 231 et 242 (Fig. 1).

L'horloge 25 comprend également une bascule JK 256, dont les entrées J et $\overline{K}$ sont à « O », et une porte OU 257 dont les entrées sont reliées à la sortie Q de la bascule 256 et à l'entrée D de l'horloge 25 et dont la sortie est reliée à l'entrée de commande de verrouillage de la bascule 250. L'entrée RA1 de remise à « 1 » et l'entrée d'horloge H de la bascule 256 sont reliées aux entrées D et F. L'entrée de commande de verrouillage de la bascule 250 est au niveau haut, et par suite, la bascule 250 est déverrouillée, après une impulsion de début sur l'entrée D jusqu'à l'impulsion suivante de fin sur l'entrée F. Puis la bascule 250 est verrouillée jusqu'à la prochaine impulsion de début, c'est-à-dire l'horloge 25 est arrêtée afin que la mémoire 20 soit gérée par l'unité de traitement 1.

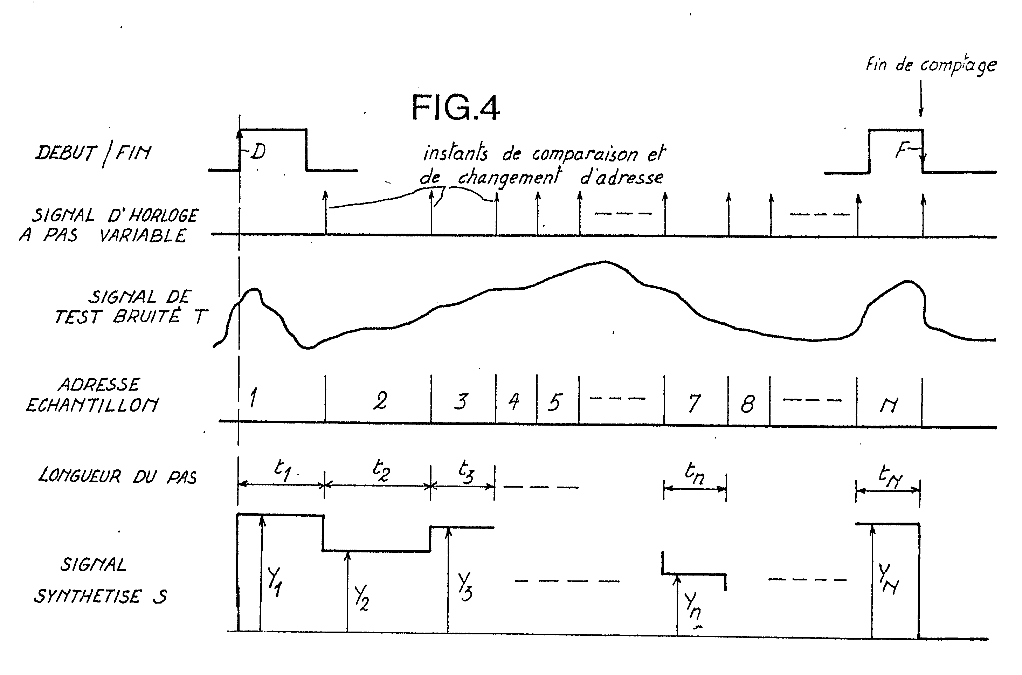

Dans l'horloge 25, un décodeur de pas 258 reçoit, en parallèle, les quatre bits des mots $t_1$ à $t_N$ qui représentent les valeurs numériques des pas élémentaires d'horloge et qui sont délivrés sur un bus 202 par la mémoire 20 sur ordre du compteur d'adresse 26. Le décodeur 258 modifie la constante RC déterminant la largeur de l'impulsion de la bascule à verrouillage 250. Il comprend, selon l'exemple illustré, quatre commutateurs qui sélectionnent ou courtcircuitent chacun une résistance en fonction de l'état du bit du rang associé dans le mot reçu $t_n$. Il apparaît ainsi que la durée entre deux échantillonnages est constituée par une durée constante qui est égale à la somme des durées de 1 µs des impulsions successives fournies par les bascules monostables 251 à 253 et par la durée variable de l'impulsion fournie par la bascule 250. Comme montré aux Figs. 1 et 4, le front montant du signal de debut sur le fil D remet à zéro (RAZ) le compteur d'adresse 26, lequel transmet à travers un circuit d'accès 3, les adresses premières cellules $Y_1$, $R_1$, $t_1$. Puis le décodeur de pas 258 de l'horloge 25 reçoit à travers le bus 202 le mot $t_1$. Après un premier pas de durée $t_1$ correspondant à la mémorisation des caractéristiques $Q_1$, $Q_2$ du signal d'erreur relatif au premier échantillon, l'impulsion à la sortie 255 de l'horloge 25 commande les bascules bistables 231 et 242 et incrémente d'une unité le compteur d'adresse 26, lequel à son tour transmet sur son bus de sortie 260 les adresses des cellules $Y_2$, $R_2$ et $t_2$ relatives au second échantillon. Ces séquences de durées variables $t_1$ à $t_N$ se poursuivent jusqu'à ce que le compteur d'adresse 26 ait son compte égal à N et émette le signal de fin de cycle sur le fil F, ce qui indique l'arrêt de l'échantillonnage dans le capteur 2. Cet échantillonnage sera repris lors de l'apparition d'un nouveau signal de début D correspondant à la période suivante du signal de test T.

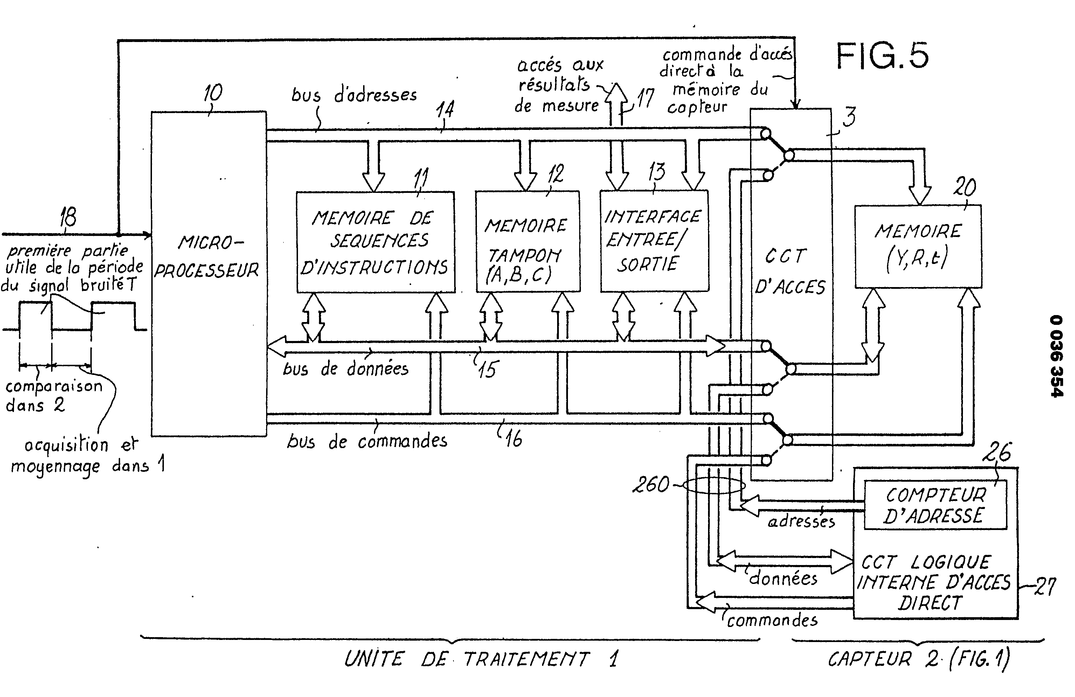

On notera que, pour chaque cycle, le compteur d'adresse 26 adresse en lecture les cellules Y et t et en écriture les cellules R. En fait, comme montré schématiquement à la Fig. 5, le compteur d'adresse 26 est inclu dans un circuit logique interne 27 ayant accès directement à la mémoire 20. Ce circuit logique 27 est relié par un bus 260 à la mémoire 20 à travers le circuit d'accès 3 et transmet, outre les adresses sous contrôle du compteur 26, certaines données et commandes telles que des instructions, en dépendance de l'état du compteur 26, pour permettre les lectures et écritures convenables des mots contenus dans la mémoire 20. Les mots t représentant les valeurs numériques des pas de l'horloge 25 sont préprogrammés dans la mémoire morte de séquences d'instructions de l'unité de traitement 1 — comme on le verra dans la suite — et sont écrits dans les cellules correspondantes de la mémoire 20 du capteur 2 pendant la seconde partie de chaque période du signal bruité T.

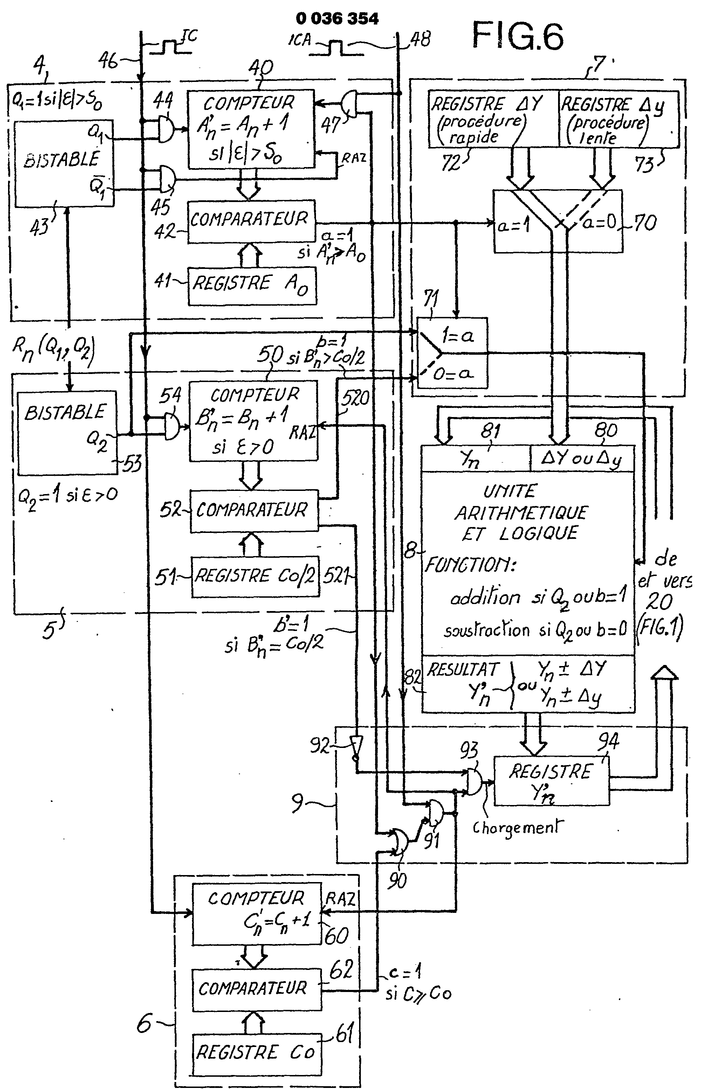

En se reportant maintenant à la Fig. 5 puis à la Fig. 6, on décrit l'unité de traitement 1 qui permet, pendant chaque période du signal de test T, après le signal de fin F, de calculer les nouvelles valeurs numériques Y des échantillons afin d'acquérir par moyennage le signal de test dénué de bruit.

Telle que montrée schématiquement à la Fig. 5, l'unité de traitement 1 est de préférence organisée autour d'un microprocesseur 10, par exemple du type INTEL 8080 ou MOTOROLA 6800. Comme il est connu, ce microprocesseur 10 est associé à une mémoire morte 11, c'est-à-dire à adressage uniquement en lecture, à une mémoire vive 12 servant de tampon, et à une interface d'entrée-sortie 13. Les circuits 11, 12, 13 sont reliés au microprocesseur 10 ainsi qu'à la mémoire d'échantillons 20 du capteur 2 par l'intermédiaire du circuit d'accès 3, à travers un bus d'adresses unidirectionnel 14, un bus de données bidirectionnel 15 et un bus de commande unidirectionnel 16. La mémoire 11 contient, outre les différentes valeurs numériques t des pas d'horloge, les séquences d'instructions du logiciel du microprocesseur 10 qui est propre au calcul de l'acquisition et du moyennage des échantillons. La mémoire tampon 12 enregistre certaines valeurs itératives A, B, C pour chaque cycle du programme correspondant à une période du signal de test T. L'interface d'entrée/sortie 13 permet de transmettre sur un bus 17 à des moyens d'affichage, tels qu'une imprimante ou une console de visualisation (non représentée), les résultats des mesures effectués par calcul numérique sur le signal synthétisé après la fin de la procédure d'acquisition.

Par ailleurs, le microprocesseur 10 et le circuit d'accès 3 reçoivent sur un fil 18 un signal d'enveloppe du signal de test T afin que, pendant la période utile du signal (entre D et F), le circuit d'accès 3 relie la mémoire 20 à l'unité logique interne d'accès direct 27 du capteur 2, via le bus 260, pour procéder aux calculs des caractéristiques du signal d'erreur $\varepsilon$ pour chaque échantillon et afin que, pendant une durée inférieure ou égale au laps de temps suivant où le signal de test T est absent, les bus 14, 15 et 16 soient reliés à la mémoire 20 et que le microprocesseur lit les résultats des comparaisons $R_1$ à $R_N$ et écrit les nouvelles valeurs calculées des échantillons $Y_1$ à $Y_N$.

Afin de montrer les opérations qu'effectue le microprocesseur 10, on a représenté schématiquement à la Fig. 6 uniquement l'unité de calcul qui est incluse dans l'unité de traitement selon une réalisation en logique câblée. Les fonctions de cette unité de calcul correspondent aux opérations du logiciel du microprocesseur 10. Elle effectue le traitement des résultats de comparaison $R = Q_1 \, Q_2$ et calcule la nouvelle valeur de chaque échantillon au cours de la seconde partie d'une période (entre F et D) du signal de test T.

L'unité de calcul de la Fig. 6 comprend pour l'essentiel trois circuits de comparaison 4, 5 et 6, un circuit de sélection de l'écart d'échantillon 7, une unité arithmétique et logique 8 et un circuit logique 9 pour réinitialiser les autres circuits et transmettre la nouvelle valeur Y' de l'échantillon.

Chacun des circuits de comparaison 4, 5, 6 comprend un compteur 40, 50, 60, un registre 41, 51, 61 et un comparateur 42, 52, 62 qui compare pour chaque échantillon respectivement le compte du compteur et le contenu du registre. Selon l'exemple illustré, les comparateurs comparent des mots à 8 bits.

Le circuit de comparaison 4 comprend également une bascule bistable 43 dont la sortie $Q_1$ est reliée, à travers une porte ET 44, à l'entrée de comptage du compteur 40 et dont la sortie complémentaire $\overline{Q}_1$ est reliée, à travers une porte ET 45, à l'entrée de remise à zéro (RAZ) du compteur 40. Une bascule bistable 53 est également incluse dans le circuit de comparaison 5 et à sa sortie $Q_2$ qui est reliée à l'entrée de comptage du compteur 50 à travers une porte ET 54. Les autres entrées des portes ET 44, 45, 54 ainsi que l'entrée de comptage du compteur 60 sont commandées par une impulsion dite de comptage IC qui est transmise sur un fil 46 pour initialiser le début du calcul de chaque échantillon.

Le circuit de comparaison 4 comprend également une porte ET 47 dont la sortie est reliée à l'entrée de décomptage du compteur 40. L'une des entrées de la porte ET 47 est reliée à la sortie du comparateur 42, qui est elle-même reliée à l'une des entrées d'une porte OU 90 du circuit logique 9 et à l'entrée de commande de sélecteurs 70 et 71 du circuit de sélection 7. L'autre entrée de la porte ET 47 est reliée à un fil 48 qui transmet des impulsions dites de calcul ICA également vers une entrée d'une porte ET 91 du circuit logique 9 dont l'autre entrée est reliée à la sortie de la porte OU 90.

Dans le circuit de sélection 7, le sélecteur 70 a deux bus d'entrée reliés à deux registres 72 et 73 qui sont respectivement assignés aux procédures rapide et lente, c'est-à-dire qui incluent le taux d'incrémentation ou de décrémentation élevé $\Delta Y$ de l'échantillon et le taux d'incrémentation ou de décrémentation petit $\Delta y$ de l'échantillon. Le sélecteur 70 sélectionne le contenu de l'un des registres 72 et 73 selon l'état logique a de la sortie du comparateur 42 pour le transmettre à un premier registre d'entrée tampon 80 de l'unité arithmétique et logique 8. Le sélecteur 71 sélectionne la sortie $Q_2$ de la bascule 53 ou une première sortie 520 du comparateur 52 sous la commande de l'état logique a de la sortie du comparateur 42. Si a = 1 ce qui correspond à une procédure rapide, le sélecteur 71 transmet l'état $Q_2$ de la sortie de la bascule 53 afin que l'unité arithmétique 8 additionne ou soustrait à la valeur numérique précédente $Y_n$ de l'échantillon le contenu $\Delta Y$ du registre 72 selon que $Q_2 = 1$ ou $Q_2 = 0$. Si a = 0, ce qui correspond à une procédure lente, le sélecteur 71 transmet l'état logique b de la première sortie 520 du comparateur 52 afin que l'unité arithmétique 8 additionne ou soustrait à la valeur numérique précédente $Y_n$ le contenu $\Delta y$ du registre 73 selon que b = 1 ou b = 0. L'unité 8 comprend un second registre tampon d'entrée 81 contenant la valeur numérique précédente $Y_n$ de l'échantillon et un registre tampon de sortie 82 qui reçoit le résultat $Y'_n$ de l'addition ou de la soustraction.

Le circuit logique 9 comprend, outre la porte ET 91 et la porte OU 90 dont l'autre entrée est reliée à la sortie du comparateur 62, également un inverseur 92, une porte ET 93 et un registre 94 dans lequel est chargée la nouvelle valeur de l'échantillon contenue dans le registre de sortie 82 sous la commande de la sortie de la porte 93. La sortie de la porte 91 commande la remise à zéro (RAZ) des compteurs 50 et 60 et est reliée à une entrée de la porte ET 93. L'autre entrée de la porte ET 93 est reliée à travers l'inverseur 92 à une seconde sortie 521 du comparateur 52.

On décrit maintenant l'algorithme pour l'acquisition et le moyennage d'un échantillon, c'est-à-dire correspondant au logiciel du microprocesseur 10 mémorisé dans la mémoire de séquences d'instructions 11 (Fig. 5). Cet algorithme est valable pour n'importe quel échantillon Y. Par ailleurs, pour ne pas surcharger la Fig. 6, ne sont pas représentés tous les composants électroniques destinés à l'entrée des paramètres relatifs aux contenus $A_n$, $B_n$ et $C_n$ des compteurs 40, 50 et 60 à partir de la mémoire 12 et $Y_n$ du registre d'entrée 81 à partir de la mémoire 20 du capteur et destinés à la sortie du contenu $Y'_n$ du registre 94 vers la mémoire 20. Egalement, pour un échantillon donné, on n'a pas représenté les moyens pour transférer le mot $R_n = Q_1 Q_2$ de la mémoire 10 vers les entrées des bascules 43 et 53. Les impulsions IC et ICA ainsi que d'autres nécessaires à la commande de certains composants de la Fig. 6 sont supposées être transmises par une unité de commande et une horloge en relation avec la mémoire d'instructions 11.

Pour décrire l'algorithme relatif à un échantillon ayant la valeur numérique $Y_n$, on suppose que, après la fin de la première partie d'une période du signal du test T qui est suivie par la seconde partie pendant laquelle les échantillons $Y_1$ à $Y_{N-1}$ sont traités, les états des compteurs 40, 50 et 60 sont mis respectivement à $A_n$, $B_n$, $C_n$ qui correspondent aux paramètres de l'échantillon $Y_n$ comparé au signal de test de ladite période. Cette comparaison a donné un résultat $Q_1 Q_2$ mémorisé dans la cellule $R_n$ de la mémoire 20 et transmis aux entrées des bascules 43 et 53. Au début du cycle, le registre 81 contient la valeur $Y_n$.

Au début du calcul, une impulsion de comptage IC est transmise sur le fil 46 qui déclenche l'incrémentation d'une unité du compteur 60 et sélectivement en fonction de l'état de $Q_1$ et $Q_2$ l'incrémentation d'une unité des compteurs 40 et 50. Le compte $C'_n = C_n + 1$ du compteur 60 est donc égal au nombre de périodes du signal de test pour lesquelles l'échantillon du signal synthétisé S a été comparé au signal de test T. D'après ce qui a été dit en référence aux Figs. 1 et 2, $Q_1 = 1$ signifie que $|\varepsilon| > S_0$ ce qui met le compte du compteur 40 à $A'_n = A_n + 1$, et $Q_1 = 0$ signifie que $|\varepsilon| \leqslant S_0$ ce qui met à travers la porte ET 45 le compte à zéro du compteur 40 : $A'_n = 0$. Le compteur 40 contient donc le nombre de périodes successives où le module du signal d'erreur $\varepsilon$ pour l'échantillon considéré est supérieur à $S_0$. De même, à la sortie de la bascule 53, $Q_2 = 1$ signifie que l'échantillon du signal d'erreur $\varepsilon$ est positif ce qui incrémente le compte $B'_n = B_n + 1$ du compteur 50 d'une unité à travers la porte ET 54. Si $Q_2 = 0$, le compte du compteur 50 reste à $B'_n = B_n$. Le compte du compteur 50 contient donc le nombre de périodes où l'échantillon correspondant du signal d'erreur est positif.

Le comparateur 42 compare le compte $A'_n$ du compteur 40 avec un premier nombre prédéterminé $A_0$ qui est contenu dans le registre 41. Si l'état a de la sortie du comparateur 42 est « 1 », ceci signifie que $A'_n \geqslant A_0$, c'est-à-dire que l'échantillon du signal synthétisé S est très statistiquement différent de celui du signal de test T ($|\varepsilon|$ statistiquement plus grand que $S_0$) ; il est nécessaire de diminuer cette différence élevée par une incrémentation à pas élevé $\Delta Y$. Par suite, si a = 1, le sélecteur 70 est en phase de procédure rapide et transfère l'incrément $\Delta Y$ du registre 72 vers le registre d'entrée 80 de l'unité arithmétique et logique 8. Egalement, si a = 1, le sélecteur 71 transmet la valeur $Q_2$ à l'unité 8. Si $Q_2 = 1$ ($\varepsilon > 0$), la valeur $Y_n$ de l'échantillon est beaucoup trop petite et doit être augmentée ce qui est réalisé par l'addition $Y'_n = Y_n + \Delta Y$. Dans le cas contraire, c'est-à-dire où $Q_2 = 0$ ($\varepsilon \leqslant 0$), l'unité 8 effectue la soustraction $Y'_n = Y_n - \Delta Y$.

Dans le cas où a = 0, ce qui signifie que $A < A_0$ et que la valeur de l'échantillon du signal synthétisé avoisine dans une large mesure celle du signal de test, aux fluctuations de bruit près, il est nécessaire d'affiner la valeur de l'échantillon $Y_n$ par une procédure lente à faible incrément $\Delta y$. Le sélecteur 70 transfère le contenu $\Delta y$ du registre 73 dans le registre d'entrée 80 de l'unité 8 et le sélecteur 71 transfère l'état b de la première sortie 520 du comparateur 52 dans l'unité 8.

Dans le circuit de comparaison 5, le registre 51 contient un nombre $C_0/2$ égal à la moitié d'un second nombre prédéterminé pair $C_0$ contenu dans le registre 61. L'état b = 1 de la première sortie 520 du comparateur 52 signifie $B'_n > C_0/2$ et l'état b = 0 signifie $B'_n \leqslant C_0/2$. L'état b' = 1 de la seconde sortie 521 du comparateur 52 signifie $B'_n = C_0/2$. Par suite, pour un nombre de périodes $C'_n$ égal à $C_0$, si b = 1 ($\varepsilon$ statistiquement

positif sur $C_0$ périodes) l'addition $Y'_n = Y_n + \Delta y$ est réalisée dans l'unité 8 et si b = 0 ($\varepsilon$ statistiquement négatif sur $C_0$ périodes) la soustraction $Y'_n = Y_n - \Delta y$ est réalisée. Si b' = 1 ($\varepsilon$ statistiquement nul sur $C_0$ périodes) la porte 93 reste fermée et la valeur de l'échantillon n'est pas modifiée $Y'_n = Y_n$.

Dans le circuit de comparaison 6, le comparateur 62 a sa sortie à c = 1 si le résultat de la comparaison du compte $C'_n$ du compteur 60 avec le contenu $C_0$ du registre 61 est tel que $C \geq C_0$, et à c = 0 si $C < C_0$. On voit d'après les liaisons des portes 90, 91 et 93 que, sous la commande d'une impulsion de calcul ICA sur le fil 48, une nouvelle valeur de $Y'_n = Y_n \pm \Delta Y$ ou $\pm \Delta y$ est transférée du registre 82 de l'unité 8 vers le registre 94, c'est-à-dire vers la mémoire 20 du capteur 2, pour l'un des deux cas suivants :

si a = 1 : le nombre de périodes successives du signal de test T pour lesquelles $|\varepsilon| > S_0$ est suffisamment élevé ($\geq A_0$) pour justifier la modification de $Y_n$ par la procédure rapide ;

si c = 1 : le nombre de périodes du signal de test T pour lesquelles l'échantillon $Y_n$ a été comparé à celui du signal de test T est suffisamment élevé pour justifier une évaluation statistique du signe de $\varepsilon$ et une modification de $Y_n$ en conséquence, par la procédure lente.

On voit d'après les liaisons des portes 90 et 91 que l'impulsion de calcul ICA décrémente d'une unité le compteur 40, à travers la porte ET 47, si a = 1, et commande également la remise à zéro (RAZ) des compteurs 50 et 60 si a = 1 ou c = 1.

Dans les autres cas, c'est-à-dire si a = 0 ou c = 0, aucune opération n'est effectuée sur $Y_n$ et la nouvelle valeur $Y'_n$ est égale à $Y_n$.

La nouvelle valeur $Y'_n$ est transmise à la mémoire 20 du capteur 2 pour la comparaison pendant la période suivante du signal de test T. Cette comparaison est suivie d'un nouveau calcul de la valeur de l'échantillon à partir des valeurs des résultats $R'_n$ et des paramètres $Y'_n$, $A'_n$, $B'_n$ et $C'_n$ et ainsi de suite pour chaque échantillon selon l'algorithme prédécrit.

A titre d'indication, le demandeur a obtenu une réduction du bruit d'au moins 20 dB avec une durée d'acquisition inférieure à 10 s pour un signal synthétisé obtenu à partir d'un signal d'essai inséré dans un signal vidéo présentant un rapport signal/bruit de 30 dB, et pour les valeurs suivantes des paramètres précités :

$A_0 = 16$ ;  $C_0 = 4$ ;  $\Delta Y = 16$ ;  $\Delta y = 1$  et $S_0 = 20 \times p \times G$ où p est égal au pas de quantification dans le convertisseur numérique-analogique 21 et G le produit des gains internes du convertisseur 21 et du soustracteur 22.

Bien que l'invention ait été décrite selon un exemple préféré de réalisation, d'autres variantes facilement imaginables par l'homme du métier peuvent être conçues dans le cadre des revendications annexées. Ceci est particulièrement le cas pour la circuiterie des Figs. 5 et 6 et également pour l'horloge 25 qui peut être organisée autour d'un diviseur de fréquence programmable classique. On notera également que l'unité de traitement 1 à microprocesseur 10 de la Fig. 5 peut être conçue pour gérer plusieurs capteurs 2 qui fonctionnent sur différents signaux de test. Ces signaux de test peuvent être, relativement au domaine de la télévision, le signal d'essai non filtré, la forme d'onde de luminance, la forme d'onde de chrominance détectée en amplitude, la forme d'onde de chrominance détectée en phase et la forme d'onde du signal multisalve détectée en amplitude.

**Revendications**

1. Dispositif d'acquisition et de moyennage à des instants d'échantillonnage prédéterminés d'un signal périodique bruité (T) dont chaque période est composée d'une première partie et d'une seconde partie avec et sans ledit signal périodique bruité (T) respectivement, caractérisé en ce qu'il comprend : des moyens (22) pour soustraire pendant la première partie de ladite période la valeur du signal périodique bruité (T) à chacun desdits instants d'échantillonnage à un échantillon analogique (S), qui correspond lui aussi audit instant d'échantillonnage et dont la valeur numérique (Y) est précalculée pendant au plus la seconde partie d'une période qui précède immédiatement ladite période afin de produire un signal d'erreur analogique ($\varepsilon$), des moyens (23, 24) pour comparer le signal d'erreur ($\varepsilon$) à zéro, à un seuil de tension prédéterminé ($S_0$) et à son opposé ($-S_0$) afin de produire audit instant d'échantillonnage un premier bit ($Q_1$) représentatif de la grandeur du module ($|\varepsilon|$) du signal d'erreur par rapport audit seuil de tension ($S_0$) et un second bit ($Q_2$) représentatif du signe du signal d'erreur, des premiers moyens de mémorisation (20 : Y, R) pour mémoriser au moins lesdites valeurs numériques (Y) et lesdits premiers et seconds bits ($Q_1$, $Q_2$), des moyens (21) pour convertir lesdites valeurs numériques en lesdits échantillons analogiques (S), et des moyens de calcul numérique (1, 25-27) pour lire pendant ladite période en synchronisme les premiers et seconds bits ($Q_1$, $Q_2$) mémorisés pendant ladite période et lesdites valeurs numériques précalculées et mémorisées dans la période qui précède immédiatement ladite période, ces moyens de calcul numériques étant aussi réalisés pour précalculer et ensuite mémoriser dans lesdits premiers moyens de mémorisation, pendant au plus la seconde partie de ladite période, des nouvelles valeurs numériques (Y') qui sont statistiquement plus voisines des valeurs correspondantes du signal périodique bruité que les valeurs numériques calculées pendant la période qui précède immédiatement ladite période.

2. Dispositif conforme à la revendication 1, dans lequel les moyens de calcul numériques (1, 25-27) comprennent des premiers moyens de comptage et de comparaison (4, 70) recevant pendant ladite période le premier bit ($Q_1$) relatif audit instant d'échantillonnage pour sélectionner

un premier (Δy) ou un second (Δy) incrément selon qu'un premier nombre (A_n) de fois où le module du signal d'erreur relatif audit instant d'échantillonnage est supérieur audit seuil de tension (S_0) pendant des périodes consécutives qui précèdent ladite période, est supérieur ou strictement inférieur à un premier nombre prédéterminé (A_0), des seconds moyens de comptage et de comparaison (5, 71) recevant le second bit (Q_2) relatif audit instant d'échantillonnage et commandés par lesdits premiers moyens de comptage et de comparaison (4, 70) pour sélectionner le second bit (Q_2) ou un troisième bit (b) selon que le premier (ΔY) ou le second (Δy) incrément est sélectionné, les états dudit troisième bit (b) indiquant un second nombre (B_n) de fois où le signal d'erreur (ε) relatif audit instant d'échantillonnage est statistiquement positif (B_n > C_0/2) ou négatif (B_n ≤ C_0/2) pendant un second nombre prédéterminé (C_0) de périodes consécutives qui précèdent ladite période, et des moyens arithmétiques (8) pour additionner ou soustraire ledit premier incrément (ΔY) à la valeur numérique (Y_n) correspondant audit instant d'échantillonnage selon que le signal d'erreur (ε) relatif audit instant d'échantillonnage est positif ou négatif, ou pour additionner ou soustraire ledit second incrément (Δy) à la valeur numérique (Y_n) correspondant audit instant d'échantillonnage selon que le second nombre de fois (B_n) est strictement supérieur ou inférieur à la moitié (C_0/2) dudit second nombre prédéterminé, afin de produire ladite nouvelle valeur numérique (Y'_n) correspondant audit instant d'échantillonnage.

3. Dispositif conforme à la revendication 2, dans les moyens de calcul numérique (1, 25-27) duquel ledit second nombre de fois (B_n) est remis à zéro chaque fois que les premiers moyens de comptage et de comparaison (4, 70) sélectionnent le premier incrément (ΔY) ou chaque fois que des deuxièmes moyens de comptage et de comparaison (6) comptent ledit second nombre prédéterminé (C_0) de périodes consécutives qui précèdent ladite période.

4. Dispositif conforme à la revendication 2 ou 3, dans les moyens de calcul numériques (1, 25-27) duquel ledit premier nombre de fois (A_n) est remis à zéro chaque fois que le module du signal d'erreur (ε) relatif audit instant d'échantillonnage (Y_n) est inférieur audit seuil prédéterminé (S_0).

5. Dispositif conforme à l'une des revendications 2 à 4, dans lequel les moyens de calcul numériques (1, 25-27) comprennent des moyens (10, 12) pour mémoriser au moins lesdits premier et second nombres de fois (A_n, B_n) pendant chaque première partie de ladite période.

6. Dispositif conforme à l'une des revendications 2 à 5, dans lequel les moyens de calcul numériques (1, 25-27) sont organisés autour d'un microprocesseur (10).

7. Dispositif conforme à l'une des revendications 1 à 6 comprenant des moyens (20, 25, 27) pour sélectionner lesdits instants d'échantillonnage.

8. Dispositif conforme à la revendication 7, dans lequel les moyens sélectionnant lesdits instants d'échantillonnage comprennent des seconds moyens de mémorisation (20 : t) pour mémoriser les valeurs des intervalles temporels (t) entre chacun des instants d'échantillonnage et l'instant d'échantillonnage suivant, des moyens de temporisation (25) initialisés au début de ladite première partie de ladite période pour produire un signal d'horloge audit instant d'échantillonnage, et des moyens d'adressage (26) commandés par ledit signal d'horloge pour adresser en lecture et en écriture lesdits premiers moyens de mémorisation (20 : Y, R) et en lecture lesdits seconds moyens de mémorisation (20 : t) afin de transmettre au moins les valeurs desdits intervalles temporels (t) aux seconds moyens de mémorisation (20 : t), lesdits moyens d'adressage (26) stoppant lesdits moyens d'adressage (26) stoppant lesdits moyens de temporisation (25) après un nombre prédéterminé (N) desdits instants d'échantillonnage.

9. Dispositif conforme à la revendication 8, dans lequel les moyens de temporisation (25) comprennent une ou plusieurs bascules monostables (250 ou 250 à 253) bouclées sur elles-mêmes, des moyens (256, 257) pour débloquer l'une (250) desdites bascules pendant ledit nombre prédéterminé d'instants d'échantillonnage et des moyens de décodage (258) des valeurs desdits intervalles temporels (t) lues dans les seconds moyens de mémorisation (20 : t) pour modifier au moins une caractéristique de la constante de temps (RC) d'une ou plusieurs bascules monostables (250 ou 250 à 253) en fonction de la valeur de l'intervalle temporel lue (t).

**Claims**

1. Device for acquiring and averaging at predetermined sampling times, samples of a noisy periodic signal (T), each period of which is made up of a first portion and a second portion with and without said noisy periodic signal (T) respectively, characterized in that it comprises : means (22) for subtracting during the first portion of said period the value of the noisy periodic signal (T) at each of said sampling times from an analog sample (S) that also corresponds to said sampling time and whose digital value (Y) is precalculated during at least the second portion of a period that immediately precedes said period, to produce an analog error signal (ε), means (23, 24) for comparing the error signal (ε) with zero, a predetermined voltage threshold (S_0) and the opposite thereof (− S_0) to produce at said sampling time a first bit (Q_1) representative of the magnitude of the modulus (|ε|) of the error signal with respect to said voltage threshold (S_0) and a second bit (Q_2) representative of the sign of the error signal, first memorizing means (20 : Y, R) for memorizing at least said digital values (Y) and said first and

second bits ($Q_1$, $Q_2$), means (21) for converting said digital values into said analog samples (S), and digital calculating means (1, 25-27) to read in synchronism during said period the first and second bits ($Q_1$, $Q_2$) that are memorized during said period, and said digital values that are precalculated and memorized during the period immediately preceding said period, said digital calculating means being also provided to precalculate and then memorize into said first memorizing means during at most the second portion of said period, new digital values (Y') that are statistically closer to the corresponding values of the noisy periodic signal in comparison with the digital values precalculated during the period that immediately precedes said period.

2. Device according to claim 1, wherein said digital calculating means (1, 25-27) comprise first counting and comparing means (4, 70) receiving during said period the first bit ($Q_1$) relative to said sampling time for selecting a first ($\Delta Y$) or a second ($\Delta y$) increment depending on whether a first number ($A_n$) of times where the error signal modulus relative to said sampling time is greater than said voltage threshold ($S_0$) throughout consecutive periods that precede said period, is greater than or strictly less than a first predetermined number ($A_0$), second counting and comparing means (5, 71) receiving the second bit ($Q_2$) relative to said sampling time and controlled by said first counting and comparing means (4, 70) for selecting the second bit ($Q_2$) or a third bit (b) depending on whether the first ($\Delta Y$) or second ($\Delta y$) increment is selected, the states of said third bit (b) indicating a second number ($B_n$) of times where the error signal ($\varepsilon$) related to said sampling time is statistically positive ($B_n > C_0/2$) or negative $B_n \leqslant C_0/2$) throughout a second predetermined number ($C_0$) of consecutive periods that precede said period, and arithmetic means (8) for adding said first increment ($\Delta Y$) to or subtracting it from the digital value ($Y_n$) corresponding to said sampling time depending on whether the error signal ($\varepsilon$) relative to said sampling time is positive or negative, or for adding said second increment ($\Delta Y$) to or subtracting it from the digital value ($Y_n$) corresponding to said sampling time depending on whether the second number of times ($B_n$) is strictly greater than or less than half ($C_0/2$) of said second predetermined number, in order to produce said new digital value ($Y'_n$) corresponding to said sampling time.

3. Device according to claim 2, wherein in the digital calculating means (1, 25-27) said second number of times ($B_n$) is reset to zero each time the first counting and comparing means (4, 70) select the first increment ($\Delta Y$) or each time second counting and comparing means (6) count said second predetermined number ($C_0$) of consecutive periods that precede said period.

4. Device according to claim 2 or 3, wherein in the digital calculating means (1, 25-27) said first number of times ($A_n$) is reset to zero each time the modulus of the error signal ($\varepsilon$) relative to said sampling time ($Y_n$) is less than said predetermined threshold ($S_0$).

5. Device according to one of claims 2 to 4, wherein the digital calculating means (1, 25-27) comprise means (10, 12) for memorizing at least said first and second numbers of times ($A_n$, $B_n$) during each first portion of said period.

6. Device according to one of claims 2 to 5, wherein the digital calculating means (1, 25-27) are organized around a microprocessor (10).

7. Device according to one of claims 1 to 6 comprising means (20, 25, 27) for selecting said sampling times.

8. Device according to claim 7 wherein the sampling time selecting means comprise second memorizing means (20 : t) for memorizing the values of the time intervals (t) between each of the sampling times and the successive sampling time, timing means (25) triggered at the start of said first portion of said period for producing a clock signal at said sampling time, and addressing means (26) controlled by said clock signal for reading and writing addressing said first memorizing means (20 : Y, R) and for reading addressing said second memorizing means (20 : t) to transmit at least the values of said time intervals (t) to said second memorizing means (20 : t), said addressing means (26) stopping said timing means (25) after a predetermined number (N) of said sampling times.

9. Device according to claim 8, wherein the timing means (25) comprise one or several monostable flips-flops (250 or 250 to 253) looped therebetween, means (256, 257) for unblocking one (250) of said flips-flops during said predetermined number of the sampling times and means (258) for decoding the values of said time intervals (t) read in said second memorizing means (20 : t) to modify at least one characteristic of the time constant (RC) of one or several monostable flips-flops (250 or 250 to 253) in terms of the read value of the sampling time (t).

**Ansprüche**

1. Einrichtung zur Gewinnung und zur Mittelung in vorbestimmten Zeitpunkten von Vergleichswerten eines rauschbehafteten periodischen Signals (T), bei denen jede Periode aus einem ersten Abschnitt und einem zweiten Abschnitt mit bzw. ohne das rauschbehaftete periodische Signal (T) zusammengesetzt ist, dadurch gekennzeichnet, daß die Einrichtung eine Subtraktionseinrichtung (22) für die während des ersten Periodenabschnitts erfolgende Subtraktion des rauschbehafteten periodischen Signalwertes (T) in jedem Vergleichswertbildungszeitpunkt von einem analogen Vergleichssignal (S), das ebenfalls dem Zeitpunkt des Vergleichswertes entspricht und dessen digitaler Wert (Y) höchstens während des zweiten Abschnitts einer unmittelbar der Periode vorangehenden Periode vorausberechnet ist, um ein analoges Fehlersignal ($\varepsilon$) zu bilden, Komparatoreinrichtungen (23, 24) für den Vergleich des Fehler-

signals ($\varepsilon$) mit Null, mit einem vorbestimmten Spannungsschwellenwert ($S_0$) und mit seinem Gegenwert ($-S_0$), um im Vergleichswertbildungszeitpunkt ein erstes, für die Größe des Moduls ($|\varepsilon|$) des Fehlersignals mit Bezug auf den Spannungsschwellenwert ($S_0$) repräsentatives Bit ($Q_1$) und ein zweites, für das Vorzeichen des Fehlersignals repräsentatives Bit ($Q_2$) zu erzeugen, erste Speichereinrichtungen (20 : Y, R) für die Speicherung mindestens der digitalen Werte (Y) und der ersten und zweiten Bits ($Q_1$, $Q_2$), eine Umsetzereinrichtung (21) für die Umsetzung der digitalen Werte in die analogen Vergleichswerte (S), und eine digitale Recheneinrichtung (1, 25-27) umfaßt, um während der Periode synchron die ersten und zweiten, während der Periode gespeicherten Bits ($Q_1$, $Q_2$) und die vorausberechneten und in der der Periode unmittelbar vorangehenden Periode gespeicherten digitalen Werte zu lesen, wobei die digitale Recheneinrichtung des weiteren für die Vorausberechnung und nachfolgende während höchstens des zweiten Periodenabschnitts erfolgende Speicherung in der ersten Speichereinrichtung von neuen digitalen Werten (Y') eingerichtet ist, die statistisch den entsprechenden Werten des rauschbehafteten periodischen Signals näher benachbart sind als die während der der Periode unmittelbar vorangehenden Periode berechneten digitalen Werte.

2. Einrichtung nach Anspruch 1, in welcher die digitale Recheneinrichtung (1, 25-27) eine erste Zähler- und Komparatoreinrichtung (4, 70) für die während der ersten Periode erfolgende Aufnahme des ersten Bits ($Q_1$) mit Bezug auf den Vergleichswertbildungszeitpunkt zur Auswahl eines ersten ($\Delta Y$) oder zweiten ($\Delta y$) Inkrementes, je nachdem ob eine erste Anzahl ($A_n$) von Malen, wo der Modul des Fehlersignals mit Bezug auf den Vergleichswertbildungszeitpunkt größer ist als der spannungsschwellenwert ($S_0$) während aufeinanderfolgender, der Periode vorangehender Perioden, größer oder durchweg geringer ist als eine erste vorbestimmte Anzahl ($A_0$), eine zweite Zähler- und Komparatoreinrichtung (5, 71) für die Aufnahme des zweiten Bits ($Q_2$) mit Bezug auf den Vergleichswertbildungszeitpunkt und gesteuert von der erster Zähler- und Komparatoreinrichtung (4, 70) zur Auswahl des zweiten Bits ($Q_2$) oder eines dritten Bits (b), je nachdem ob das erste ($\Delta Y$) oder das zweite ($\Delta y$) Inkrement ausgewählt wird, wobei die Zustände des dritten Bits (b) eine zweite Anzahl ($B_n$) von Malen anzeigen, wo das Fehlersignal ($\varepsilon$) mit Bezug auf den Vergleichswertbildungszeitpunkt statistisch positiv ($B_n > C_0/2$) oder negativ ($B_n \leqslant C_0/2$) ist während einer zweiten vorbestimmten Anzahl ($C_0$) von der Periode vorangehenden aufeinanderfolgenden Perioden, und eine arithmetische Einrichtung (8) umfaßt für das Addieren und Subtrahieren des ersten Inkrementes ($\Delta Y$) von dem zum Vergleichswertbildeungszeitpunkt gehörenden digitalen Wert ($Y_n$), je nachdem, ob das Fehlersignal ($\varepsilon$) mit Bezug auf den Vergleichswertbildungszeitpunkt positiv oder negativ ist, oder für das Addieren oder Subtrahieren des zweiten Inkrementes ($\Delta y$) von dem zum Vergleichswertbildungszeitpunkt gehörenden digitalen Wert ($Y_n$), je nachdem, ob die zweite Anzahl ($B_n$) von Malen durchweg größer oder kleiner ist als die Hälfte ($C_0/2$) der zweiten vorbestimmten Anzahl, um den neuen, dem Vergleichswertbildungszeitpunkt entsprechenden digitalen Wert ($Y'_n$) zu erzeugen.

3. Einrichtung nach Anspruch 2, in welcher in der digitalen Recheneinrichtung (1, 25-27) die zweite Anzahl von Malen ($B_n$) jedesmal auf Null zurückgestellt wird, wenn die erste Zähler- und Komparatoreinrichtung (4, 70) das erste Inkrement ($\Delta Y$) auswählt, oder jedesmal dann, wenn die zweite Zähler- und Komparatoreinrichtung (6) die zweite vorbestimmte Anzahl ($C_0$) von aufeinanderfolgenden Perioden zählt, welche der Periode vorangehen.

4. Einrichtung nach Anspruch 2 oder 3, in welcher in der digitalen Recheneinrichtung (1, 25-27) die erste Anzahl von Malen ($A_n$) jedesmal auf Null zurückgestellt wird, wenn der Modul des Fehlersignals ($\varepsilon$) mit Bezug auf den Vergleichswertbildungszeitpunkt ($Y_n$) kleiner ist als der vorbestimmte Schwellenwert ($S_0$).

5. Einrichtung nach einem der Ansprüche 2 bis 4, in welcher die digitale Recheneinrichtung (1, 25-27) eine Speichereinrichtung (10, 12) umfaßt, welche mindestens die erste und die zweite Anzahl von Malen ($A_n$ $B_n$) während jedes ersten Periodenabschnitts speichert.

6. Einrichtung nach einem der Ansprüche 2 bis 5, in welcher die digitale Recheneinrichtung (1, 25-27) um einen Mikroprozessor (10) aufgebaut ist.

7. Einrichtung nach einem der Ansprüche 1 bis 6, mit einer Auswahleinrichtung (20, 25, 27) für die Auswahl der Vergleichswertbildungszeitpunkte.

8. Einrichtung nach Anspruch 7, in welcher die Auswahleinrichtung für die Vergleichswertbildungszeitpunkte eine zweite Speichereinrichtung (20 : t) für die Speicherung der zeitlichen Intervalwerte (t) zwischen jedem Vergleichswertbildungszeitpunkt und dem folgenden Vergleichswertbildungszeitpunkt, eine Zeitgebereinrichtung (25), welche zu Beginn des ersten Periodenabschnitts zur Erzeugung eines Taktsignals im Vergleichswertbildungszeitpunkt startet, und eine Adressiereinrichtung (26) umfaßt, welche durch das Taktsignal zur Adressierung beim Lesen und beim Schreiben der ersten Speichereinrichtung (20 : Y, R) und beim Lesen der zweiten Speichereinrichtung (20 : t) für das Übertragen mindestens der zeitlichen Intervallwerte (t) zu der zweiten Speichereinrichtung (20 : t) gesteuert wird, wobei die Adressiereinrichtung (26) die Zeitgebereinrichtung (25) nach einer vorbestimmten Anzahl von Vergleichswertbildungszeitpunkten (N) stoppt.

9. Einrichtung nach Anspruch 8, in welcher die Zeitgebereinrichtung (25) eine oder mehrere rückgekoppelte monostabile Kippschaltungen (250 oder 250 bis 253), eine Entriegelungseinrichtung (256, 257) für die Auslösung einer Kippschaltung (250) während der vorbestimmten Anzahl von Vergleichsbildungszeitpunkten und eine Dekodiereinrichtung (258) für die in der zweiten Speichereinrichtung (20 : 6) gelesenen zeitlichen Intervallwerte (t) umfaßt, um mindestens eine Größe der Zeitkonstante (RC) einer oder mehrerer monostabiler Kippschaltungen (250 oder 250 bis 253) in Abhängigkeit von dem gelesenen zeitlichen Intervallwert (t) zu modifizieren.

# FIG.1

CAPTEUR 2

MEMOIRE A N ECHANTILLONS

Signal de test bruité T

Soustracteur 22

CONVERTISSEUR N/A  — signal synthétisé S

$\varepsilon = T - S$  220

Valeurs numériques des échantillons : $Y_1$, $Y_2$, ... $Y_H$

Comparateur 231 / 230 / 23

$Q_2$ 201

Résultats des comparaisons : $R_1$, $R_2$, ... $R_H$

comparateur double seuil 240 / 241 / 242 / 243 / 24  $\pm S_0$ / $-S_0$

$Q_1'$ 202

Valeurs numériques des pas d'horloge : $t_1$, $t_2$, ... $t_N$

HORLOGE A PAS VARIABLE (FIG.3) 25

données / commandes / adresses  20 / 3

C.C.T. D'ACCES

255

260

COMPTEUR D'ADRESSE 26  RAZ / F / D

de et Vers unité de traitement 1 (Figs. 5 et 6)

200 / 21

**0 036 354**

FIGs, 2

A — Entrées du soustracteur 22

Signal synthétisé S

Signal de test bruité T

B — Sortie 220 du soustracteur 22

$+S_0$

$0$

$-S_0$

Signal d'erreur $\varepsilon = T-S$

C — Sortie du comparateur 230

$Q_2$ 0 1 1 1 0 0 1 0

D — Sortie du comparateur 240

$\varepsilon > S_0$

E — Sortie du comparateur 241

$\varepsilon < -S_0$

F — Sortie Porte ou 243

$Q_1$ 0 0 0 1 0 1 0 0

$|\varepsilon| > S_0$

Résultats $R(Q_1, Q_2)$ des comparaisons

2

# FIG.3

HORLOGE A PAS
VARIABLE 25

Signal d'horloge

vers 26, 231, 242
(FIG.1)

3

FIG.4

Fin de comptage

DEBUT / FIN

instants de comparaison et
de changement d'adresse

SIGNAL D'HORLOGE
A PAS VARIABLE

SIGNAL DE
TEST BRUITÉ T

ADRESSE
ECHANTILLON

LONGUEUR DU PAS

SIGNAL
SYNTHETISE S

0 036 354

FIG.5

accés aux résultats de mesure 17

commande d'accés direct à la mémoire du capteur

bus d'adresses 14

10 MICRO-PROCESSEUR

11 MEMOIRE DE SEQUENCES D'INSTRUCTIONS

12 MEMOIRE TAMPON (A,B,C)

13 INTERFACE ENTREE/SORTIE

3 CCT D'ACCES

20 MEMOIRE (Y,R,t)

18 première partie utile de la période du signal bruité T

comparaison dans 2

acquisition et moyennage dans 1

bus de données 15

bus de commandes 16

260

adresses

26 COMPTEUR D'ADRESSE

données

27 CCT LOGIQUE INTERNE D'ACCES DIRECT

commandes

UNITE DE TRAITEMENT 1

CAPTEUR 2 (FIG.1)

0 036 354

FIG.6

0 036 354